# FASCICULE DE BREVET EUROPEEN

(11) **EP 1 259 104 B1**
(45) Date de publication et mention de la délivrance du brevet: **23.04.2008**
(21) Numéro de dépôt: 02290883.4
(22) Date de dépôt: 09.04.2002
(51) Int. Cl.: H05K 7/20, H02M 7/00

(54) **Système convertisseur de puissance pour véhicule de traction ferroviare**
Leistungswandlersystem eines Schienenfahrzeuges
Power converter system for a railway vehicle

(30) Priorité: 18.05.2001 FR 0106589
(43) Date de publication de la demande: 20.11.2002
(73) Titulaire: Alstom, 92300 Levallois-Perret (FR)
(72) Inventeur: Fellmann, Daniel, 65420 Ibos (FR); Cettour-Rose, Jacques, 65200 Ordizan (FR)
(74) Mandataire: de Lambilly Delorme, Marie Pierre

(56) Documents cités:
- DE-A- 4 307 061
- DE-A- 19 914 565
- PATENT ABSTRACTS OF JAPAN vol. 018, no. 480 (E-1603), 8 septembre 1994 (1994-09-08) & JP 06 163770 A (HITACHI LTD), 10 juin 1994 (1994-06-10)

## Description

L'invention se rapporte à un système convertisseur de puissance destiné à un véhicule de traction ferroviaire et plus particulièrement à un système convertisseur de puissance comportant un onduleur dont les composants semi-conducteurs de puissance sont refroidis par un fluide caloporteur.

Classiquement, les systèmes convertisseurs de puissance du domaine ferroviaire utilisent des onduleurs refroidis par air, dits à panneaux secs, comportant des modules électroniques de puissance disposés directement sur une face plane d'un radiateur en aluminium, ce dernier étant muni de multiples ailettes de refroidissement sur la face opposée. De tels onduleurs refroidis par air présentent l'avantage d'offrir une maintenance aisée, le démontage du radiateur, qui sert de structure support aux modules électroniques de puissance, permettant d'avoir rapidement accès aux principaux organes de l'onduleur.

De tels radiateurs de refroidissement par air présentent toutefois l'inconvénient d'être lourd et volumineux et d'offrir des capacités de refroidissement limitées, en particulier lorsque le flux d'air traversant le radiateur est faible. Or, les onduleurs du domaine ferroviaire fonctionnent sous de forte tension et utilisent des composants semi-conducteurs de puissance de type IGBT (de l'anglais Insulated Gate Bipolar Transistor; transistor bipolaire à grille isolée) présentant la particularité d'admettre un courant maximal qui est fonction de la quantité de chaleur que le dispositif de refroidissement est capable d'évacuer. Ainsi, les performances de ces onduleurs sont directement liées aux capacités de refroidissement des composants IGBT.

Il est connu d'améliorer le refroidissement des composants semi-conducteurs de puissance des onduleurs en utilisant un fluide caloporteur tel que de l'eau (voir par exemple le document DE 199 14 565). Toutefois, de tels onduleurs refroidis par eau comportent un circuit de refroidissement muni d'un échangeur de chaleur qui est structurellement indépendant de la partie électrique de l'onduleur et qui est habituellement fixé indépendamment sur le véhicule ferroviaire de telle sorte qu'une intervention de maintenance sur des modules de puissance de l'onduleur nécessite la déconnexion de plusieurs conduites du circuit d'eau ce qui complique considérablement les opérations de maintenance.

Aussi, un but de la présente invention est de proposer un système convertisseur de puissance pour véhicule de traction ferroviaire comportant un onduleur refroidi par circulation d'un fluide caloporteur et possédant un agencement permettant une maintenance aisée.

A cet effet, l'invention a pour objet un système convertisseur de puissance pour véhicule de traction ferroviaire comprenant un onduleur comportant une pluralité de dispositifs à semi-conducteurs de puissance refroidis par circulation d'un fluide caloporteur, l'onduleur étant raccordé à un circuit de refroidissement comprenant un échangeur de chaleur, caractérisé en ce que l'onduleur et le circuit de refroidissement sont fixés sur une même plaque support, l'onduleur étant disposé sur une face de la plaque support et l'échangeur de chaleur étant disposé en vis-à-vis sur la face opposée.

Selon des modes particuliers de réalisation, le système convertisseur de puissance selon l'invention peut comprendre l'une ou plusieurs des caractéristiques suivantes prises isolément ou selon toutes les combinaisons techniquement possibles :
- la plaque support est fixée au véhicule ferroviaire en un lieu adapté pour que l'échangeur de chaleur soit balayé par un flux d'air lors du déplacement du véhicule ;
- le circuit de refroidissement comporte des conduits traversant la plaque support ;
- le circuit de refroidissement comporte une pompe et un vase d'expansion qui sont disposés sur la face de la plaque supportant l'onduleur ;
- l'onduleur est disposé dans un coffre de protection, la plaque supportant l'onduleur servant de panneau de fermeture d'une ouverture présente sur une paroi du coffre, l'échangeur de chaleur restant disposé à l'extérieur du coffre de protection ;
- la plaque support déborde de l'ouverture du coffre et comporte un joint d'étanchéité sur sa périphérie ;
- l'échangeur de chaleur fonctionne par convection naturelle, sans faire appel à un ventilateur ;
- l'échangeur de chaleur est entouré au moins partiellement par une grille de protection ;
- les composants semi-conducteurs de puissance sont des composants IGBT.

On comprendra mieux les buts, aspects et avantages de la présente invention, d'après la description donnée ci-après d'un mode particulier de réalisation de l'invention, présenté à titre d'exemple non limitatif, en se référant aux dessins annexés, dans lesquels :
- la figure 1 est une vue schématique d'un véhicule ferroviaire comportant un coffre de protection dans lequel est monté un système convertisseur de puissance selon un mode particulier de réalisation de l'invention ;
- la figure 2 est une vue schématique agrandie du système convertisseur de puissance de la figure 1 dans son coffre de protection;
- la figure 3 est une vue en perspective d'un système convertisseur de puissance de la figure 2 hors du coffre de protection.

Pour faciliter la lecture du dessin, seuls les éléments nécessaires à la compréhension de l'invention ont été représentés. Les mêmes éléments portent les mêmes références d'une figure à l'autre.

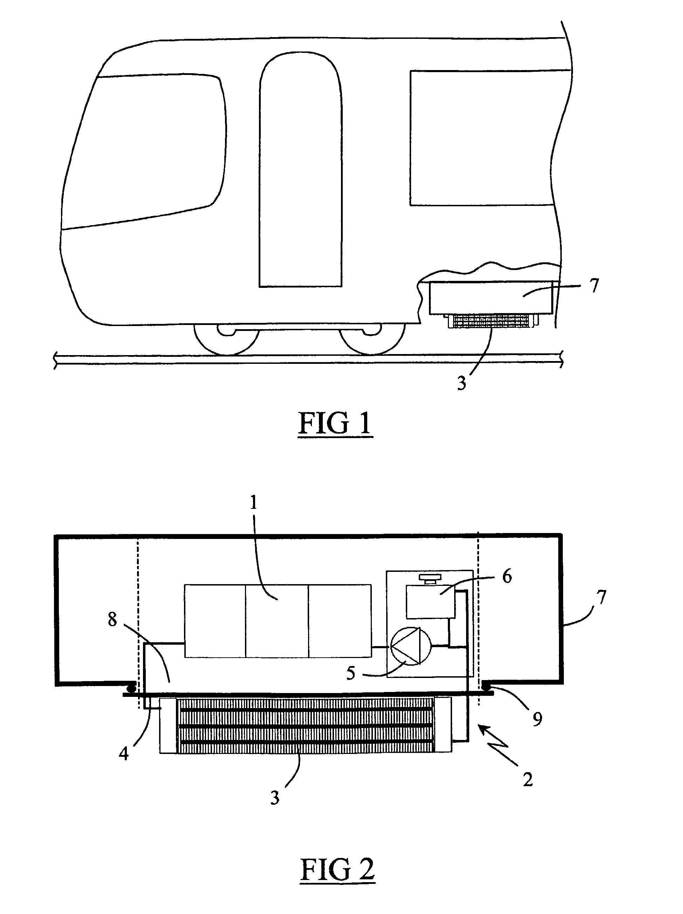

La figure 1 représente un métro équipé d'un système convertisseur de puissance permettant la transformation d'un courant continu, disponible au niveau d'un rail d'alimentation, en un courant alternatif triphasé adapté pour alimenter des moteurs de traction.

Conformément à cette figure 1, le système convertisseur de puissance comporte un onduleur 1 refroidi par eau disposé à l'intérieur d'un coffre de protection 7 fixé sous le châssis du métro, l'onduleur 1 étant raccordé à un circuit de refroidissement 2 comprenant un échangeur de chaleur air/eau 3 disposé à l'extérieur du coffre de protection 7 et balayé par un flux d'air lors du déplacement du véhicule.

Le coffre de protection 7, représenté de manière plus détaillée sur la figure 2, comporte une paroi inférieure munie d'une ouverture 8 qui est obturée par un panneau de fermeture 4, ce dernier servant également de plaque support à l'onduleur 1, au circuit de refroidissement 2 et à l'échangeur air/eau 3.

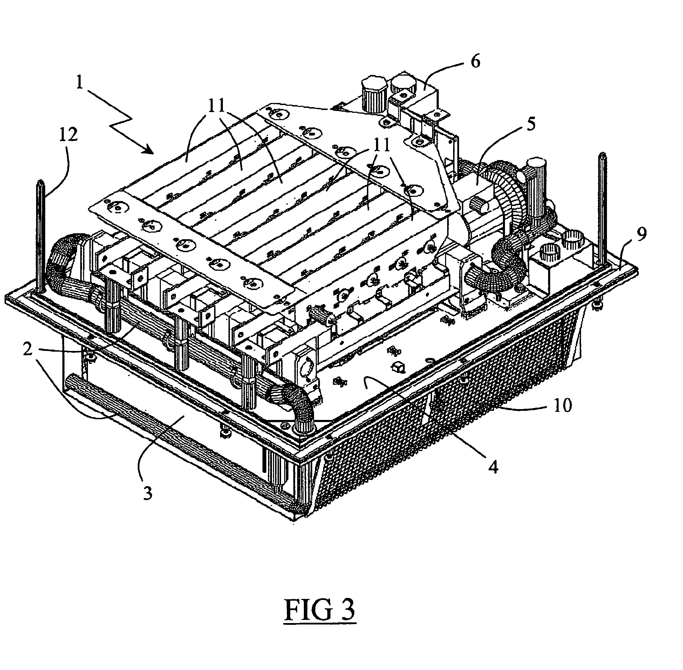

L'onduleur 1, représenté plus en détail sur la figure 3, est fixé sur la face supérieure du panneau de fermeture 4 et comporte six éléments de refroidissement 11, tels que décrits dans la demande de brevet FR-A1-2 775 416 déposée par la demanderesse, disposés côte à côte. Ces éléments de refroidissement 11 sont réalisés en matériau électriquement isolant et supportent chacun cinq modules électroniques de puissance à base de composants IGBT, connectés en parallèle, les trois phases de l'onduleur 1 étant constituées chacune par l'association en parallèle des modules électroniques de puissance de deux éléments de refroidissement 11. Pour assurer un refroidissement efficace des composants IGBT, chaque élément de refroidissement 11 comporte un volume intérieur de circulation d'eau qui amène l'eau au contact des embases des modules électronique de puissance, les six éléments de refroidissement 11 étant hydrauliquement connectés en parallèle pour réduire les pertes de charges.

L'onduleur 1, ainsi constitué des six éléments de refroidissement 11 et des modules électroniques de puissance associés, est connecté à des conduites cheminant sur la face supérieure du panneau de fermeture 4 et appartenant au circuit de refroidissement 2.

Conformément aux figures 2 et 3, ce circuit de refroidissement 2 est muni d'une pompe de circulation d'eau 5 et d'un vase d'expansion 6 disposés sur la face supérieure du panneau de fermeture 4, et comporte des conduites traversant le panneau de fermeture 4 et assurant la connexion avec une partie du circuit de refroidissement 2, comprenant essentiellement l'échangeur air/eau 3, disposée sous la face inférieure du panneau 4. Cet échangeur air/eau 3 comporte de multiples ailettes de refroidissement espacées les unes des autres d'un pas de l'ordre de 7 mm et est protégé par une grille 10, représentée uniquement sur la figure 3, rapportée autour de l'échangeur 3, dont les barreaux sont espacés d'un pas d'environ 1 cm. L'échangeur air/eau 3 fonctionne par convection naturelle, sans ventilateur, permettant ainsi de limiter son encrassement.

La périphérie de la face supérieure du panneau de fermeture 4 est munie d'un joint d'étanchéité 9 qui vient s'appuyer sur les bords de l'ouverture du coffre 7 lorsque le panneau de fermeture 4 est mis en place, ce dernier comportant deux tiges de fixations 12 présentant un embout fileté venant coopérer avec un alésage réalisé dans le fond du coffre 7 pour assurer l'immobilisation du panneau 4 sur le coffre 7.

Un tel système convertisseur de puissance présente l'avantage d'avoir un onduleur parfaitement protégé des agressions extérieures par le coffre de protection et un échangeur air/eau disposé dans flux d'air qui est protégé des chocs éventuels par la grille de protection. De plus, dans le mode de réalisation particulier de l'invention précédemment décrit, le fonctionnement par convection naturelle de l'échangeur air/eau, sans intervention d'un ventilateur de refroidissement, associé à l'écartement relativement important, de l'ordre de 7 mm, des ailettes de refroidissement réduit considérablement les risques d'encrassement de l'échangeur.

Un tel système convertisseur de puissance présente également l'avantage d'être extrêmement compact et d'offrir une maintenance facilitée par le regroupement sur une même plaque support, constitué dans l'exemple précédemment décrit par le panneau de fermeture du coffre, des fonctions onduleur, circuit de refroidissement et échangeur de chaleur. Ainsi, les interventions de maintenance sur l'onduleur ne nécessitent qu'une dépose du panneau de fermeture sans aucune ouverture du circuit d'eau.

De plus, grâce à l'efficacité du refroidissement par eau, le convertisseur de puissance ainsi réalisé peut comporter moins de composants de puissance, ces derniers supportant une puissance supérieure, ce qui permet de réduire le coût de la fonction onduleur sur un véhicule ferroviaire.

Un tel convertisseur de puissance présente également l'avantage d'avoir une masse et un volume réduit par rapport aux convertisseurs à panneaux secs de l'art antérieur et de pouvoir ainsi être aisément utilisé en deuxième monte pour remplacer les convertisseurs à panneaux secs, sans entraîner de modifications importantes de l'architecture d'implantation du convertisseur sur le véhicule.

Bien entendu, l'invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention.

Ainsi, dans une variante de réalisation non représentée de l'invention, l'échangeur de chaleur peut comporter, de manière connue en soi, un ventilateur de refroidissement afin d'augmenter les échanges thermiques et permettre ainsi l'augmentation de la puissance de fonctionnement des composants semi-conducteurs.

## Revendications

1. Système convertisseur de puissance pour véhicule de traction ferroviaire comprenant un onduleur (1) comportant une pluralité de dispositifs à semi-conducteurs de puissance refroidis par circulation d'un fluide caloporteur, ledit onduleur (1) étant raccordé à un circuit de refroidissement (2) comprenant un échangeur de chaleur (3), **caractérisé en ce que** ledit onduleur (1) et ledit circuit de refroidissement (2) sont fixés sur une même plaque support (4), ledit circuit de refroidissement (2) comportant une pompe (5) et un vase d'expansion (6) qui sont disposés, avec ledit onduleur (1), sur une face de la plaque support (4), ledit échangeur de chaleur (3) étant disposé en vis-à-vis sur la face opposée de la plaque support (4).

2. Système convertisseur de puissance selon la revendication 1, **caractérisé en ce que** la plaque support (4) est fixée sous le châssis du véhicule ferroviaire, l'échangeur de chaleur (3) étant disposé horizontalement sous la plaque support (4) de manière à être balayé par un flux d'air lors du déplacement du véhicule.

3. Système convertisseur de puissance selon l'une quelconque des revendications 1 à 2, **caractérisé en ce que** ledit circuit de refroidissement (2) comporte des conduits traversant la plaque support (4).

4. Système convertisseur de puissance selon l'une quelconque des revendications 1 à 3, **caractérisé en ce que** ledit onduleur (1) est disposé dans un coffre de protection (7), la plaque (4) supportant l'onduleur (1) servant de panneau de fermeture d'une ouverture (8) présente sur une paroi dudit coffre (7), l'échangeur de chaleur (3) restant disposé à l'extérieur du coffre de protection (7).

5. Système convertisseur de puissance selon la revendication 4, **caractérisé en ce que** la plaque support (4) déborde de l'ouverture (8) du coffre (7) et comporte un joint d'étanchéité (9) sur sa périphérie.

6. Système convertisseur de puissance selon l'une quelconque des revendications 1 à 5, **caractérisé en ce qu** ledit échangeur de chaleur (3) fonctionne par convection naturelle, sans faire appel à un ventilateur.

7. Système convertisseur de puissance selon l'une quelconque des revendications 1 à 6, **caractérisé en ce que** ledit échangeur de chaleur (3) est entouré au moins partiellement par une grille de protection (10).

8. Système convertisseur de puissance selon l'une quelconque des revendications 1 à 7, **caractérisé en ce que** lesdits composants semi-conducteurs de puissance sont des composants transistors bipolaires à grille isolée.

## Claims

1. Power converter system for a rail traction vehicle, comprising an inverter (1) having a plurality of power semiconductor devices cooled by the circulation of a heat-carrying fluid, said inverter (1) being connected to a cooling circuit (2) comprising a heat exchanger (3), **characterised in that** the inverter (1) and the cooling circuit (2) are fixed to the same support plate (4), said cooling circuit (2) comprising a pump (5) and an expansion reservoir (6) which are arranged, with said inverter (1), on one side of the support plate (4), said heat exchanger (3) being arranged in a facing position on the opposite side of the support plate (4).

2. Power converter system according to claim 1, **characterised in that** the support plate (4) is fixed underneath the chassis of the rail vehicle, the heat exchanger (3) being arranged horizontally underneath the support plate (4) so as to be swept by a flow of air while the vehicle is in motion.

3. Power converter system according to any one of claims 1 to 2, **characterised in that** the cooling circuit (2) comprises lines passing through the support plate (4).

4. Power converter system according to any one of claims 1 to 3, **characterised in that** the inverter (1) is arranged in a protective casing (7), the plate (4) supporting the inverter (1) acting as a closure panel for an opening (8) provided on one wall of said casing (7), the heat exchanger (3) remaining outside the protective casing (7).

5. Power converter system according to claim 4, **characterised in that** the support plate (4) overlaps the opening (8) of the casing (7) and comprises a sealing joint (9) on its periphery.

6. Power converter system according to any one of claims 1 to 5, **characterised in that** the heat exchanger (3) operates by natural convection, without using a fan.

7. Power converter system according to any one of claims 1 to 6, **characterised in that** the heat exchanger (3) is at least partially surrounded by a protective grille (10).

8. Power converter system according to any one of claims 1 to 7, **characterised in that** the power semiconductor components are insulated gate bipolar transistor components.

## Patentansprüche

1. Leistungswandler-System für ein Schienen-Triebfahrzeug, einen Wechselrichter (1) aufweisend, der eine Mehrzahl von Leistungshalbleiter-Vorrichtungen aufweist, die durch Zirkulation einer Kühlflüssigkeit gekühlt werden, wobei der Wechselrichter (1) an einen Kühlkreislauf (2) angeschlossen ist, der einen Wärmetauscher (3) aufweist, **dadurch gekennzeichnet, dass** der Wechselrichter (1) und der Kühlkreislauf (2) auf einer gleichen Halteplatte (4) befestigt sind, wobei der Kühlkreislauf (2) eine Pumpe (5) und einen Ausgleichsbehälter (6) aufweist, die mit dem Wechselrichter (1) auf einer Seite der Halteplatte (4) angeordnet sind, wobei der Wärmetauscher (3) gegenüber auf der entgegengesetzten Seite der Halteplatte (4) angeordnet ist.

2. Leistungswandler-System gemäß Anspruch 1, **dadurch gekennzeichnet, dass** die Halteplatte (4) unter dem Fahrgestell des Schienenfahrzeugs befestigt ist, wobei der Wärmetauscher (3) horizontal unter der Halteplatte derart angeordnet ist, dass er bei der Bewegung des Fahrzeugs von einem Luftstrom gestreift wird.

3. Leistungswandler-System gemäß einem der Ansprüche 1 bis 2, **dadurch gekennzeichnet, dass** der Kühlkreislauf (2) Leitungen aufweist, die durch die Halteplatte (4) hindurch verlaufen.

4. Leistungswandler-System gemäß einem der Ansprüche 1 bis 3, **dadurch gekennzeichnet, dass** der Wechselrichter (1) in einem Schutzkasten (7) angeordnet ist, wobei die Platte (4), die den Wechselrichter (1) hält, als Verschlussplatte für eine Öffnung (8) dient, die sich in einer Wand des Kastens (7) befindet, wobei der Wärmetauscher (3) außerhalb des Schutzkastens (7) angeordnet bleibt.

5. Leistungswandler-System gemäß Anspruch 4, **dadurch gekennzeichnet, dass** die Halteplatte (4) über die Öffnung (8) des Kastens (7) hinausgeht und an ihrem Umfang eine Dichtungsfuge (9) aufweist.

6. Leistungswandler-System gemäß einem der Ansprüche 1 bis 5, **dadurch gekennzeichnet, dass** der Wärmetauscher (3) durch natürliche Konvektion funktioniert, ohne dass ein Ventilator verwendet wird.

7. Leistungswandler-System gemäß einem der Ansprüche 1 bis 6, **dadurch gekennzeichnet, dass** der Wärmetauscher (3) zumindest teilweise von einem Schutzgitter (10) umgeben ist.

8. Leistungswandler-System gemäß einem der Ansprüche 1 bis 7, **dadurch gekennzeichnet, dass** die Leistungshalbleiter-Bauelemente Bipolartransistor-Bauelemente mit isolierter Gate-Elektrode sind.
